Europäisches Patentamt

(19) European Patent Office

Office européen des brevets

(11) Veröffentlichungsnummer: **0 046 978**

**A2**

(12) # EUROPÄISCHE PATENTANMELDUNG

(21) Anmeldenummer: **81106606.7**

(51) Int. Cl.³: **H 05 K 3/46**

(22) Anmeldetag: **26.08.81**

(30) Priorität: **02.09.80 DE 3032931**

(43) Veröffentlichungstag der Anmeldung:
**10.03.82 Patentblatt 82/10**

(84) Benannte Vertragsstaaten:
**FR GB IT**

(71) Anmelder: **Robert Bürkle GmbH & Co.**
**Postfach 160**
**D-7290 Freudenstadt(DE)**

(72) Erfinder: **Bohn, Hans**
**Sonnenhalde 12**
**D-7294 Schopfloch(DE)**

(72) Erfinder: **Stein, Wolfgang**
**Stumpengartenweg 6**
**D-7290 Freudenstadt(DE)**

(72) Erfinder: **Bernsau, Peter**
**Bärenwiesenweg 7**
**D-7291 Wittlensweiler(DE)**

(72) Erfinder: **Staubitzer, Fred**
**Eichendorffweg 5**
**D-7295 Dornstetten(DE)**

(74) Vertreter: **Frank, Gerhard, Dipl.-Phys. et al,**
**Patentanwälte Dr. F. Mayer & G. Frank Westliche 24**
**D-7530 Pforzheim(DE)**

(54) **Verfahren und Anordnung zur Herstellung von Mehrschicht-Leiterplatten.**

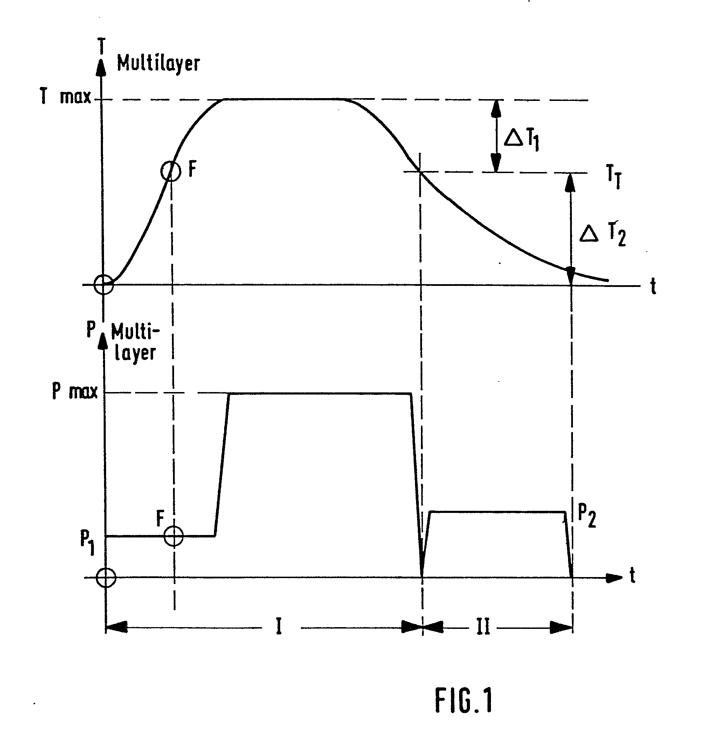

(57) Bei einem Verfahren zur Herstellung von Mehrschichtleiterplatten (Multilayer), insbesondere mit mehr als 4 Schichten, wird der Abkühlvorgang nach dem unter Druck und Hitze
erfolgenden Verschmelzen der Kunstharzzwischenschichten
auf zwei Pressen verteilt: in der ersten Presse erfolgt eine
Abkühlung auf eine Transfertemperatur, dann erfolgt die
Übergabe an die zweite Presse. Dadurch brauchen die
Heizplatten der ersten Presse nicht mehr auf Umgebungstemperatur abgekühlt zu werden, was eine beträchtliche
Energieersparnis bringt. Vorteilhafterweise führt man dabei
die beim Abkühlen der Heizplatten der ersten Presse freiwerdende Wärmemenge der zweiten Presse zur Aufheizung auf
die Transfertemperatur zu, es ist weiterhin auch möglich, die
bei der Abkühlung der zweiten Presse auf Umgebungstemperatur freiwerdende Wärmemenge wiederum bei der Aufheizung der ersten Presse auf Maximaltemperatur zu verwenden (Fig. 1).

FIG.1

— 1 —

## Verfahren und Anordnung zur Herstellung von Mehrschicht-Leiterplatten.

Die Erfindung betrifft ein Verfahren und eine Anordnung zur Herstellung von Mehrschichtleiterplatten (Multilayer) aus mehreren übereinanderliegenden Leiterplatten unter Anwendung von Druck und Hitze auf die zwischen den Leiterplatten liegenden Kunstharzfolien.

Aus verschiedenen Gründen, so zum Beispiel zur Verkürzung von Weglängen bei der Impulsverarbeitung, werden in der Elektrotechnik bzw. Elektronik Leiterplattenanordnungen eingesetzt, deren einzelne Leiterplatten übereinander geschichtet sind. Die einzelnen Leiterplatten werden in bekannter, hier nicht interessierender Weise (zum Beispiel durch Ätzverfahren) mit den Leitungsbahnen versehen.

Zur festen Verbindung der übereinanderliegenden Leiterplatten werden zwischen diese Kunstharzschichten gelegt, die unter Druck und Hitze in einen Fließzustand und dann in einen irreversiblen, festen Zustand (Duroplaste) versetzt werden, in dem sie dann die übereinandergeschichteten Leiterplatten festhalten. Dieser Vorgang erfordert die kontrollierte Zuführung von Wärme und eine darauf abgestimmte Anwendung von Druck auf das Leiterplattenpaket. Zunächst wird dem Leiterplattenpaket eine bestimmte Wärmemenge zugeführt, bis die zur Verbindung der Leiterplatten vorgesehenen Zwischenschichten in den Fließzustand gelangen, kurze Zeit nach diesem Fließzustand wird dann der maximale Preßdruck aufgebracht; nachdem dieser Preßdruck eine bestimmte Zeit aufrechterhalten worden ist, wird das Leiterplattenpaket abgekühlt, wobei dann die feste Verbindung der einzelnen Leiterplatten erfolgt.

Je nach der Schichtanzahl des Multilayers sind hierbei im wesentlichen 2 Verfahrensprizipien bekanntgeworden, die spezifische Vor- und Nachteile aufweisen:

Bis zu einer Schichtzahl von ungefähr 4 ist es möglich, das Aufheizen und das Abkühlen des Multilayers in zwei verschiedenen Vorrichtungen (Heizpresse und Kühlpresse) durchzuführen. Dies hat den Vorteil, daß die Heizpresse den Abkühlvorgang nicht mitmachen muß, sondern auf hoher Temperatur bleiben kann. Mit der Verlagerung des Abkühlprozesses in die Kühlpresse ist auch eine gewisse Zeitersparnis verbunden, da während des Abkühlvorganges die Heizpresse schon zur Bearbeitung der nächsten Multilayer zur Verfügung steht. Bei diesem Verfahren ist es erforderlich, die noch unter hoher Temperatur befindlichen Multilayerpakete von der Heizpresse zur Kühlpresse zu transferieren, wo sie dann ebenfalls unter Druckanwednung abgekühlt werden. Diese Druckanwendung ist erforderlich, um Verschiebungen und Verspannungen mit Multilayer zu vermeiden, die infolge des Abkühlprozesses auftreten können. Sofern nicht mehr als 3 Sohichten verarbeitet werden, sind diese Erscheinungen insgesamt vernachlässigbar, so daß eine druckfreie Übergabe der Multilayer von der Heizpresse zur Kühlpresse möglich ist, ohne daß irreversible Verspannungen oder Verschiebungen des Multilayers auftreten, die nacher in der Kühlpresse nicht mehr beseitigt werden könnten.

Bei mehr als 4 Multilayer-Schichten sah man sich gezwungen, ein anderes Verfahren anzuwenden. Dieses Verfahren besteht darin, eine Kombination von Heiz- und Kühlpresse in einer Anlage zu vereinigen, um eine Abkühlung der Multilayer-Schichten ohne Druckunterbrechung durchführen zu können. Die Nachteile dieses Verfahrens liegen jedoch auf der Hand: zum einen ist dieses Verfahren äußerst energieintensiv, da die zur Pressen der Multilayer-Schichten verwendeten Stahlplatten immer wieder voll abgekühlt und beim nächsten Verarbeitungsgang wieder aufgeheizt werden müssen, was infolge der hohen Wärmekapazität dieser Stahlplatten sehr unwirtschaftlich ist, außerdem ist dieses Verfahren relativ langsam, da die kombinierte Heiz- Kühlpresse für die gesamte Abkühldauer belegt bleibt.

Die Problematik besteht also kurz gesagt darin, daß man bei Mehrschicht-Leiterplatten mit mehr als 4 Schichten einen druckfreien Zustand des Multilayers bei einer Temperatur, in der sich die Zwischenschichten noch im Fließzustand befinden, nicht riskieren kann, ohne daß irreversible Formveränderungen des Multilayers zu befürchten wären, die diesen für seinen Einsatz unbrauchbar machen könnten.

Es ist daher Aufgabe der Erfindung, die bekannte Verfahren derart weiterzuentwickeln, daß auch bei mehrlagigen Schichten (Schichtzahl größer als 4) noch eine beträchtliche Energie- und Zeitersparnis erreicht werden kann.

Diese Aufgabe ist gelöst gemäß dem kennzeichnenden Teil des Patentanspruches 1.

Durch die Aufteilung des Abkühlprezesses auf zwei Pressen können die Vorteile, die bisher nur bei geringschichtigen

- 4 -

Multilayern erzielbar waren, auch bei Multilayern mit mehr als 4 Schichten weitgehend realisiert werden, ohne daß die Qualität der hergestellten Merhschichtleiterplatte darunter leidet.

Ausgestaltungender Erfindung sind den Unteransprüchen zu entnehmen.

Die Erfindung wird nun anhand eines Ausführungsbeispiels mittels Figuren erläutert.

Es zeigen:

Figur 1 : eine grafische Darstellung des Temperatur- und Druckverlaufes eines Multilayers beim erfindungsgemäßen Verfahren,

Figur 2 : eine grafische Darstellung der Temperatur der Heizplatten während aufeinanderfolgenden Arbeitszyklen,

Figur 3 : eine schematische Darstellung der erfindungsgemäßen Vorrichtung, bestehend aus der Kombination einer Heiz- Kühlpresse und einer Kühlpresse,

Figur 4 : eine Seitenansicht der erfindungsgemäßen Vorrichtung in Richtung des Pfeiles B der Figur 5 und

Figur 5 : eine Vorderansicht der erfindungsgemäßen Vorrichtung in Richtung des Pfeiles A der Figur 4.

Figur 1 zeigt eine grafische Darstellung des Temperaturverlaufes und des Druckverlaufes, dem die Mehrschichtleiterplatte während ihrer Verarbeitung ausgesetzt ist. Zunächst wird der Multilayer von der Raumtemperatur $T_R$ unter Anwendung eines geringen Druckes aufgeheizt, bis der die Zwischenschicht bildende Kunststoff seinen Fließpunkt F erreicht hat. Danach wird eine weitere Aufheizung zur Maximaltemperatur $T_{max}$ durchgeführt, während gleich- zeitig nach einer Zeitspanne $\Delta t$ nach dem Erreichen des Fließpunktes F der Druck bis zum maximalen Preßdruck $p_{max}$ erhöht wird, um das nunmehr voll fließfähige Kunststoffmaterial zwischen den Leiterplatten zu verteilen und die gewünschte Klebewirkung zu erzeugen. Dieser Druck wird für eine Multilayer-spezifische Zeitspanne aufrechterhalten und danach wird die Heizung abgeschaltet, so daß sich die Temperatur des Multilayer wieder verringert, und sich asymptotisch wieder der Raumtemperatur $T_R$ annähert. Das erfindungsgemäße Verfahren ist nun im wesentlichen dadurch gekennzeichnet, daß dieser Abkühlprozess zum Teil in einer ersten Presse (mit I angedeutet) und zum Teil in einer zweiten Presse (mit II angedeutet) verläuft. Demnach kühlt sich der Multilayer in der ersten Presse um eine Tempera- turdifferenz $\Delta T_1$ auf eine Transfertemperatur $T_T$ ab, bei der er in die zweite Presse transferiert wird, wo er sich schließlich um eine zweite Temperaturdifferenz $\Delta T_2$ bis nahe der Raumtemperatur $T_R$ abkühlen kann.

Die Transfertemperatur ist dabei so gewählt, daß der erforderliche drucklose Zustand während des Transfers von der ersten Presse zur zweiten Presse nicht mehr zu irreversiblen Formveränderungen des Multilayer-Paketes führen kann (der "Druckeinbruch" ist in der Übergangsphase I – II zu erkennen).

- 6 -

Bei der praktischen Anwendung des erfindungsgemäßen Verfahrens haben sich Temperaturen $T_{max.}$ von 140-200$^{\circ}$ ergeben, und eine Transfertemperatur $T_T$ von ca. 40 - 120$^{\circ}$ Celsius.

Die während der gesamten Verarbeitung verwendeten Vorpreßdrücke $p_1$ und $p_2$ (Kontaktdruck zur Wärmeverteilung bzw. zur Stabilisierung des Klebezustandes) liegen im Bereich von 2 - 15 Mp, der maximale Preßdruck $p_{max.}$ kann zwischen 10 und 100 $M_p$ gewählt werden.

In der schematischen Darstellung der Figur 1 ist die Zeitspanne und die Abkühlung während der Übergabe von der ersten Presse zur zweiten Presse nicht berücksichtigt, da diese Werte gegenüber den Werten für einen Verarbeitungszyklus (Größenordnung ca. 1 Stunde und ca. 100$^{\circ}$ Celsius) vernachlässigbar sind.

Aus der Darstellung der Figur 1 entnimmt man den einen Vorteil der erfindungsgemäßen Lösung ohne weiteres: bei Erreichen der Transfertemperatur $T_T$ wird der Multilayer an die zweite Presse zur weiteren Abkühlung weitergegeben, so daß die erste Presse zur Aufnahme eines weiteren Multilayers bereitsteht. Dies bewirkt eine Reduzierung der Taktzeit im Verhältnis I/I + II. Während bei der konventionellen Lösung zur Verarbeitung von mehrschichtigen Leiterplatten die gesamte Zyklusdauer (I + II) ca. 75 Minuten in Anspruch nimmt, ergibt sich beim erfindungsgemäßen Verfahren eine Taktdauer (I) von ca. 30- 45 Minuten je nach Materialart und Multilayeraufbau, also eine Reduzierung um ca. 50 %.

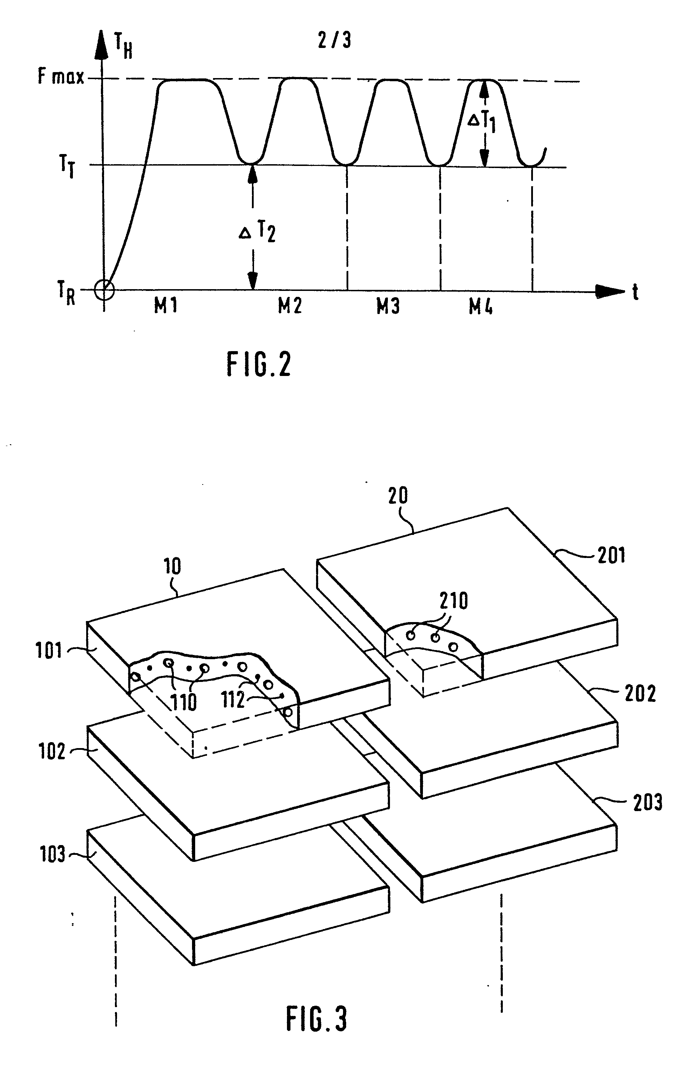

Ein weiterer Vorteil des erfindungsgemäßen Verfahrens ergibt aus der grafischen Darstellung der Figur 2, wo der Temperaturverlauf der für die Durchführung des Verfahrens erforderlichen Heizplatten der ersten Presse während mehrerer Verarbeitungszyklen M1...M4 dargestellt ist. Man erkennt, daß nach der Inbetriebnahme der erfindungsgemäßen Anorndung bei der Raumtemperatur $T_R$ die Temperatur $T_H$ der Heizplatten zwischen der Maximaltemperatur $T_{max.}$ und der Transfertemperatur $T_T$ hin- und herpendelt, daß die Temperatur der Heizplatten dabei aber immer um den Wert $\Delta T_2$ über der Raumtemperatur $T_R$ bleibt.

Gegenüber dem bekannten Verfahren ist es daher nur bei Inbetriebnahme der Anlage erforderlich, die Heizplatten von Raumtemperatur $T_R$ auf die Transfertemperatur $T_T$ aufzuheizen, danach ist bei jedem Zyklus $M_n$ nur noch diejenige Wärmemenge den Heizplatten zuzuführen, die zur Erhöhung der Temperatur von der Transfertemperatur $T_T$ auf die Maximaltemperatur $T_{max}$ erforderlich ist. Da diese Wärmezufuhr durch die Beheizung mittels Elektrostäben erfolgt, ist damit eine beträchtliche Energieersparnis erreicht.

Beide Vorteile, die Verkürzung der Taktdauer und die Energieeinsparung sind umso größer, je höher beim spezifischen Anwendungsfall die Transfertemperatur $T_T$ gewählt werden kann, dabei ist als wesentliches Kriterium (wie oben schon ausgeführt) zu berücksichtigen, daß bei dem beim Übergabezeitpunkt auftretenden drucklosen Zustand des Multilayers bei der Transfertemperatur $T_T$ keine irreversiblen Strukturveränderungen auftreten dürfen. Die Transfertemperatur $T_T$ ist daher im spezifischen Anwendungsfall individuell je nach Art des Multilayers und nach Qualitätsforderungen zu bestimmen.

Eine weitere Verbesserung des Qualität der hergestellten Multilayer läßt sich dadurch erreichen, daß man die beim Abkühlen der ersten Presse auf die Transfertemperatur $T_T$ anfallende Wärmemenge zumindest teilweise den (sich noch vom vorherigen Zyklus auf Raumtemperatur befindlichen) Preßplatten der zweiten Presse zugeführt wird, um diese auf Transfertemperatur $T_T$ zu bringen. Bei der Übergabe der Multilayer an die zweite Presse 20 wird dadurch in thermischer Hinsicht ein kontinuierlicher Übergang erreicht, mögliche ungünstige Einflüsse (z.B. lokale Verspannungen oder Verwerfungen auf die Multilayer durch den Temperaturgradienten zwischen der Transfertemperatur (Multilayer) und Raumtemperatur (Stahlplatten der zweiten Presse 20) werden dadurch vermieden.

Technisch läßt sich dies durch eine Wärmetauschersystem bewerkstelligen, bei dem ein Wärmetransportmedium die Stahlplatten der ersten Presse 10 und der zweiten Presse 20 koppelt,(z.B. mit Öl oder Wasser unter Druck als Transportmedium). Zur weiteren Verbesserung der Energiebilanz ist es auch denkbar, dieses System zu einem Wärmepumpensystem zu ergänzen, das die Abkühlung der zweiten Presse und die gleichzeitige Aufheizung der ersten Presse bewirkt oder zumindest unterstützt. Die dem Kühlsystem der zweiten Presse entzogene Wärmemenge kann dabei dem Heizsystem der ersten Presse zugeführt werden, zumindest so lange, wie die Temperaturdifferenz der beiden Pressen eine wirtschaftliche Ausnutzung des Wärmepumpenprinzips ermöglicht.

Die Figuren 3 - 5 zeigen die erfindungsgemäße Vorrichtung zur Durchführung des Verfahrens, eine zweistufige Pressanlage.

Figur 3 zeigt eine schematische Darstellung der erfindungsgemäßen Vorrichtung, die erfindungsgemäße Preßanlage besteht aus einer kombinierten Heiz- und Kühlpresse 10 und einer nachgeschalteten Kühlpresse 20.

Beide Pressen sind als Mehretagepressen ausgeführt, so besteht die erste Presse 10 aus mehreren Stahlplatten 101, 102, 103,.... und die zweite Presse entsprechend aus der gleichen Anzahl von Stahlplatten 201, 202, 203,....

Die Stahlplatten der ersten Presse 10 sind 60 mm dick und haben einen gegenseitigen Abstand von 100 mm, die Stahlplatten der zweiten Presse 20 sind 35 mm dick und haben dementsprechend einen gegenseitigen Abstand von 125 mm.

Zur Beheizung der Stahlplatten der ersten Presse 10 sind Heizstäbe 112 in die Stahlplatten eingelassen, zur Kühlung der Stahlplatten der ersten Presse 10 und der zweiten Presse 20 sind Kanäle 110 bzw. 210 zum Durchfluß des Kühlmittels (Wasser) vorgesehen.

Zwischen jeweils 2 Stahlplatten wird ein Multilayer eingeführt, und die Stahlplatten werden dann mittels nicht dargestellter Preßeinrichtungen zusammengedrückt und halten die Multilayer zwischen sich fest.

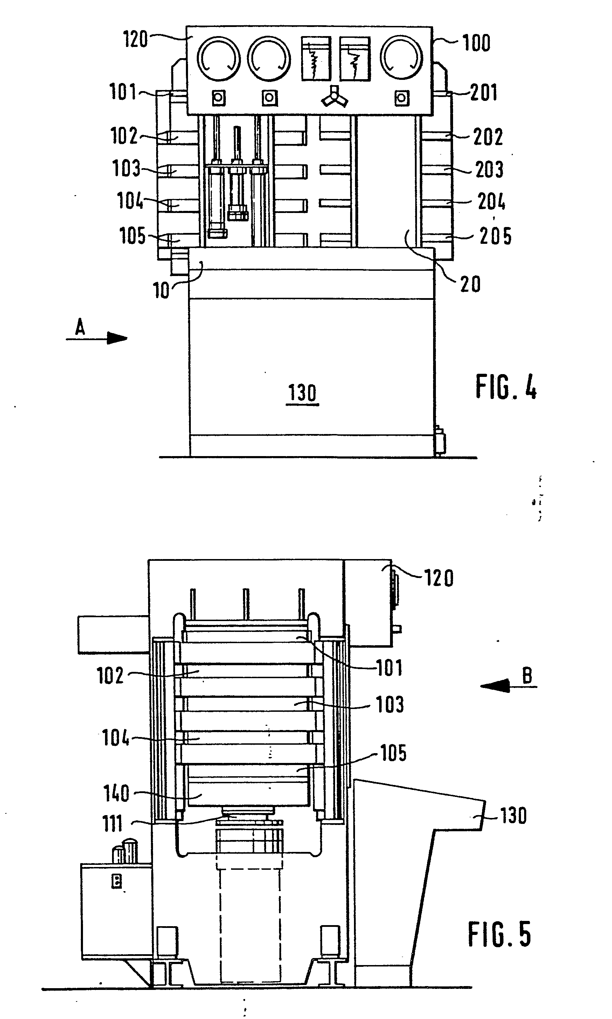

Figuren 4 und 5 zeigen Ansichten eines Ausführungsbeispieles einer kompletten Preßanlage gemäß der Erfindung, wobei die beiden Pressen 10 und 20 zu einer gemeinsamen Baueinheit 100 integriert sind.

Dargestellt ist eine Mehretagepresse mit 4 Etagen, die dementsprechend jeweils 5 Stahlplatten 101.. 105 bzw. 201 ...205 aufweist.

Diese Stahlplatten sind in einer schweren Stahlrahmenkonstruktion geführt, um eine ausreichende Preßparallelität bzw. Parallelführung der Stahlplatten zu ermöglichen. Der erforderliche Preßdruck wird von einer hydraulischen Vorrichtung 111 über einen Preßtisch 110 auf die Stahlplatten übertragen. Zum Ausgleich des Gewichtes der Stahlplatten sind Pneumatikzylinder vorgesehen, die sicherstellen, daß in jeder Etage der gleiche spezifische Preßdruck auf den Multilayer erreicht wird.

Zur Bedienung der gesamten Baueinheit 100 ist ein Bedienungspult 130 vorgesehen, über den Betriebszustand, insbesondere Drücke und Temperaturen, geben Instrumente Aufschluß, die in einem Instrumenbord 120 untergebracht sind.

Die Stahlplatten 101 - 105 bzw. 201 - 205 sind seitlich in Stangen geführt, wobei zur Gewährleistung der Parallelführung Prismen vorgesehen sind, die entsprechend den thermischen Ausdehnungen der Stahlplatten angeordnet sind, so daß die Parallelführungseingenschaften in jedem Temperaturzustand der Stahlplatten gleich sind.

P a t e n t a n s p r ü c h e :

1. Verfahren zur Herstellung von Mehrschichtleiter- platten (Multilayer) aus mehreren übereinanderliegen- den Leiterplatten unter Anwendung von Druck und Hitze auf die zwischen den Leiterplatten liegenden Kunst- harzfolien, gekennzeichnet durch folgende Ver- fahrensschritte:

a) Aufheizen des Multilayers bis zur Maximaltemperatur und Pressen in einer ersten Presse (1o),

b) Abkühlen des Multilayers in der ersten Presse (1o) auf eine Temperatur zwischen der Maximaltemperatur ($T_{max}$) und der Raumtemperatur ($T_R$)(Transfertemperatur $T_T$),

c) Übergabe des Multilayers von der ersten Presse (1o) in eine zweite Presse (2o), und

d) Abkühlen des Multilayers in der zweiten Presse (2o) bis in die Nähe der Raumtemperatur ($T_R$).

2. Verfahren nach Anspruch 1 dadurch gekennzeichnet, daß die Transfertemperatur ($T_T$) abhängig von der Art des Multilayers (Material-Schichtdicke) derart vorgegeben wird, daß Verspannungen oder Verwerfungen bei der Übergabe des Multilayers von der ersten Presse (1o) zur zweiten Presse (2o) ausgeschlossen sind.

3. Verfahren nach Anspruch 2 dadurch gekennzeichnet, daß die Transfertemperatur ($T_T$) 8o ° - 12o ° C be-

trägt und daß die Maximaltemperatur 15o$^\circ$ bis 2oo$^\circ$ C beträgt.

4. Verfahren nach Anspruch 1, dadurch gekennzeichnet, daß während des Abkühlens des Multilayers in der ersten Presse (1o) auf die Transfertemperatur ($T_T$) die dabei freiwerdende Wärmemenge zumindest teilweise der zweiten Presse (2o) zugeführt wird.

5. Verfahren nach Anspruch 1, dadurch gekennzeichnet, daß die beim Abkühlen der zweiten Presse (2o) auf die Raumtemperatur freiwerdende Wärmemenge auf ein Temperaturniveau gepumpt wird, wo sie zum Aufheizen der ersten Presse (1o) von der Transfertemperatur ($T_T$) auf die Maximaltemperatur verwendet wird.

6. Vorrichtung zur Durchführung des Verfahrens nach Anspruch 1, gekennzeichnet durch eine erste Presse (1o) mit kombinierten Heizeinrichtungen (112) und Kühleinrichtungen (11o), und eine nachgeschaltete zweite Presse (2o) mit Kühleinrichtungen (21o) (Figur 3).

7. Vorrichtung nach Anspruch 6, dadurch gekennzeichnet, daß die beiden Pressen (10, 20) Mehretagenpressen sind.

8. Vorrichtung nach Anspruch 6, oder 7, dadurch gekennzeichnet, daß die erste Presse (10) mehrere Stahlplatten (101...105) mit einer Dicke von 60 mm aufweist, die einen gegenseitigen Abstand von 100 mm aufweisen.

9. Vorrichtung nach Anspruch 6 und 7, dadurch gekennzeichnet, daß die zweite Presse (20) mehrere Stahlplatten (201...205) mit einer Dicke von 35mm aufweist, die einen gegenseitigen Abstand von 125mm aufweisen, wobei die Oberseiten der Stahlplatten der ersten Presse (10) und der zweiten Presse (20) miteinander fluchten.

10. Vorrichtung nach Anspruch 6, dadurch gekennzeichnet, daß die beiden Pressen (10. 20) zu einer Baueinheit (100) zusammengefaßt sind.

FIG.1

FIG.2

FIG.3

0046978

FIG. 4

FIG. 5